# EUROPEAN PATENT SPECIFICATION

(11) **EP 0 810 723 B1**
(45) Date of publication and mention of the grant of the patent: **01.08.2001**
(21) Application number: 96830311.5
(22) Date of filing: 31.05.1996
(51) Int. Cl.: H03H 1/00, H03F 3/45, H03F 3/72

(54) **BICMOS transconductor differential stage for high-frequency filters**
BICMOS Transkonduktanzdifferenzstufe für Hochfrequenzfilter
Etage différentiel de transconductance à BICMOS pour filtres haute fréquence

(43) Date of publication of application: 03.12.1997
(73) Proprietor: STMicroelectronics S.r.l., 20041 Agrate Brianza (Milano) (IT); CO.RI.M.ME., 95121 Catania (IT)
(72) Inventor: Pisati, Valerio, 27049 Bosnasco (Pavia) (IT); Alini, Roberto, 27049 Stradella (Pavia) (IT); Cosentino, Gaetano, 95121 Catania (IT); Vai, Gianfranco, 27100 Pavia (IT)
(74) Representative: Botti, Mario

(56) References cited:
- DE-A- 3 813 532
- FR-A- 2 672 748
- US-A- 4 390 850
- PROCEEDINGS OF THE INTERNATIONAL SYMPOSIUM ON CIRCUITS AND SYSTEMS, NEW ORLEANS, MAY 1 - 3, 1990, vol. 2 OF 4, 1 May 1990, INSTITUTE OF ELECTRICAL AND ELECTRONICS ENGINEERS, pages 1364-1367, XP000167060 CASTELLO R ET AL: "A VERY LINEAR BICMOS TRANSCONDUCTOR FOR HIGH-FREQUENCY FILTERING APPLICATIONS"
- PATENT ABSTRACTS OF JAPAN vol. 005, no. 176 (E-081), 12 November 1981 & JP-A-56 102107 (SONY CORP), 15 August 1981,

## Description

### Field of application

The present invention relates to a BiCMOS transconductor differential stage for high frequency filters and of the type comprising an input circuit portion having signal inputs and comprising a pair of MOS transistors having their respective gate terminals corresponding to the above mentioned input signals and an output circuit portion having output signals and comprising a pair of bipolar transistors connected together with a common base in a circuit node and inserted between the above mentioned inputs and the above mentioned outputs in cascode configuration.

The field of application of the present invention refers in particular but not exclusively to transconductors for time-continuous pass-band filters, which are monolithically integrated on a semiconductor, and the following disclosure is given with reference to that field of application only for the purpose of simplifying the discussion thereof.

A transconductor is essentially a voltage-controlled differential stage with transconductance. It is used to provide integrators incorporated in active filters but also to provide oscillators and circuits for the conversion of impedances.

### Prior art

In recent years there have been proposed various techniques for providing time-continuous integrated filters. The technique which has gained acceptance as the most effective for high frequency applications is the one using a BiCMOS transconductor stage as the basic block of the filter.

Inside a BiCMOS transconductor filter an open-loop voltage-current conversion is performed; for this reason, the so-called non-dominant pole of the converter is not limited by the unit frequency gain of the operational amplifier circuit portion. This is an advantage over filters provided in conformity with CMOS technology.

However, transconductor filters also have the shortcoming of being particularly sensitive to parasite capacitors just as a result of their open-loop operating mode. This limits the amplitude of their pass band and particularly at high frequencies.

A transconductor filter which seeks to obviate this limitation in the pass band is disclosed in U.S. patent no. 5,332,937 filed by the same applicant.

The solution disclosed in this U.S. patent, although advantageous in some ways, does not allow achieving band amplitudes capable of meeting current requirements.

In some applications linked to reading of the information in the mass memories of computers, e.g. in the reading of the hard disc drive there would be a need to further extend the pass band of the signal to be filtered.

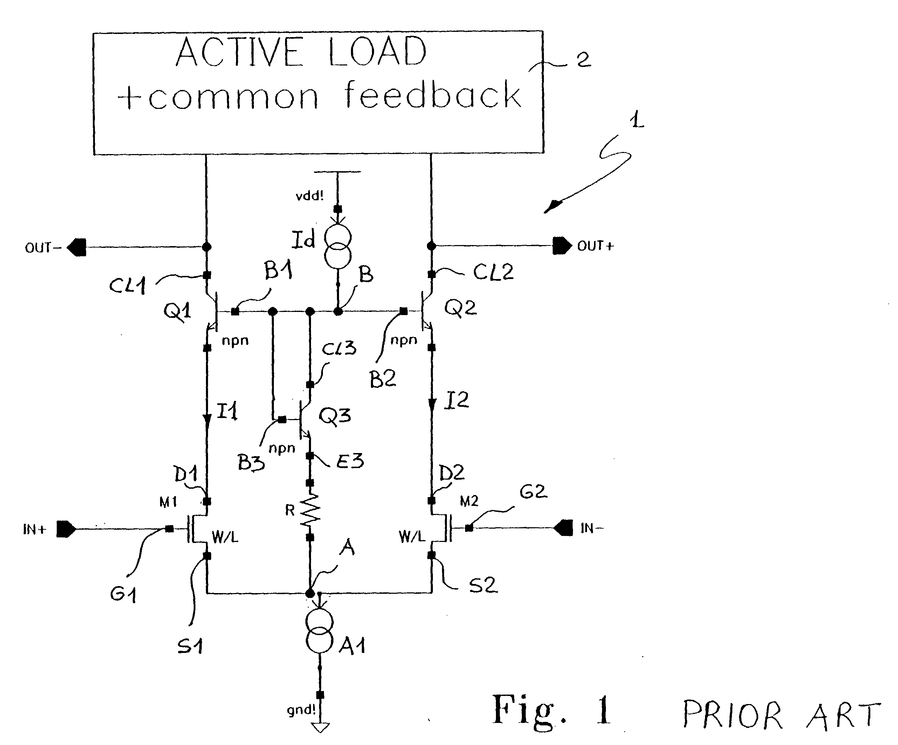

To better understand the difficulties encountered in seeking to improve the performance of time-continuous transconductor filters provided in accordance with the prior art it is useful to refer to the annexed FIG 1 in which is shown the basic diagram of a transconductor differential stage which can be incorporated in a pass band filter.

The stage 1 is powered between a first reference supply voltage Vdd and a second reference voltage GND, e.g. a signal ground. In addition, this stage is implemented by using a so-called mixed BiCMOS technology because it comprises both bipolar transistors and MOS transistors.

The stage 1 comprises an input circuit portion made up of a pair of N-channel MOS transistors M1, M2 having their respective source terminals in common to constitute a circuit node A.

The gate terminal G1 of the first M1 of these transistors constitutes a non-inverting input IN+ for the differential stage 1. The gate G2 of the other transistor M2 is the inverting input IN.

Between the circuit node A and ground there is a current generator A1.

There is also provided an output circuit portion comprising a pair of bipolar transistors Q1 and Q2 of the npn type with their respective bases B1, B2 connected together in a common node B which is powered by the reference supply voltage Vdd through a bias current generator Id.

The bipolar transistors Q1, Q2 are inserted in the stage 1 in so-called cascode configuration and have their respective emitters E1, E2 mutually connected to the drain terminals D1, D2 of the pair of MOS input transistors.

The collectors CL1 and CL2 of the bipolar transistors Q1, Q2 constitute output terminals for the stage 1 and are indicated in the FIGS respectively by OUT- and OUT+. Each of them is connected to an active load 2.

The structure of the stage 1 is completed by a third transistor Q3 of the bipolar npn type and having its base B3 connected to the bases B1 and B2 and the emitter E3 connected to the node A through a resistive element R. The third transistor Q3 has its collector CL3 connected to the bias current generator Id. The base B3 and collector CL3 of the transistor Q3 are connected together to give this transistor a diode configuration.

The input transistors M1, M2 are biased in the linear operation zone and thus bring about a linear conversion from voltage to current to determine the value of the transconductance gm of the stage 1.

The value of the resistive element R causes the drain-source voltage drop Vds of both the MOS transistors. Under linearity conditions the transistors M1 and M2 are traversed by currents I1 and I2 whose value is given by the following equation.${\text{I1 = I2 = µ Cox [(Vgs - Vt)Vds - (Vds)}}^{\text{2}} \text{/2] W/L}$ where Vgs is the gate-source voltage drop of the MOS transistors, Vt is the threshold voltage thereof, W and L are respectively the amplitude and the width of the channel region, and µ and Cox are know parameters of each transistor.

If a differential signal is applied to the inputs IN- and IN+ of the stage 1 it is possible to calculate the value of transconductance gm of the stage as the incremental ratio of the variation of the current Iout at output to the variation of the input voltage Vin = Vgs (M1) - Vgs (M2). Accordingly -$\text{gm = δIout/δVin = µ Cox Vds W/L.}$

The pole on which the pass band of the filter depends is correlated with the transconductance gm and in particular is given by the ratio gm:C where C is the value of the equivalent capacitance of the transconductor stage.

To improve the frequency performance of the filter it would be necessary to operate on one or the other of the above mentioned parameters, i.e. on the transconductance or the equivalent capacitance. For example, a solution of the prior art disclosed in the article,: "Tunable BiCMOS Continuous-Time Filter for High Frequency Application", IEEE Journal of Solid State Circuits, Dec. 1992, page 1905, proposes varying the transconductance gm of the transconductor filter depending on the requirements of the field of application. In this article there are considered possible variations in the transconductance between one and four.

The analysis made in this article shows that there exists an upper limit to the amplitude of the input signal applicable to the transconductor stage. Beyond this limit the linearity characteristics of the stage are seriously impaired.

This limit is linked to the amount of the drain-source voltage drop Vds and to the so-called overdrive of the differential stage.

The maximum peak-peak amplitude acceptable at the input to the transconductor is given by the following equation:${\text{Vin}}_{\text{max}} {\text{= gm}}_{\text{max}} {\text{*[(Vgs - Vt)- Vds]}}_{\text{M1,M2}} {\text{= 4*[(Vgs - Vt)- Vds]}}_{\text{M1,M2}}$

The pass band is thus a function of the acceptable distortion for a given input signal and depends on the drain-source voltage drop Vds located at the ends of the resistive element R.

This drain-source voltage Vds cannot be too low to avoid problems of subthreshold operation at the MOS transistors M1, M2, but neither can it increase excessively to avoid the transistors ending up in the saturation zone.

Even the solution disclosed in the above mentioned article does not meet current application requirements.

The technical problem underlying the present invention is to conceive a transconductor differential stage for high frequency filters and having structural and functional characteristics such as to allow increasing the pass band of the time-continuous filters while exceeding the limitations and/or shortcomings which still limit the filter devices provided in accordance with the prior art.

### Summary of the invention

The technical problem is solved by a transconductor differential stage of the type indicated above and defined in the characterizing part of claims 1 and following.

The characteristics and advantages of the stage in accordance with the present invention are set forth in the description of an embodiment thereof given below by way of non-limiting example with reference to the annexed drawings.

### Brief description of the drawings

In the drawings:
FIG 1 shows a diagrammatic view of the basic structure of a transconductor differential stage provided in accordance with the prior art,
FIG 2 shows a detail of a switching circuit associated in accordance with the present invention with a transconductor differential stage,
FIG 2a shows an enlarged scale view of a detail of the circuit of FIG 2,
FIG 3 shows a diagrammatic view of a transconductor differential stage incorporating a switching circuit in accordance with the present invention, and
FIG 4 shows a variant embodiment of the transconductor differential stage in accordance with the present invention.

### Detailed description

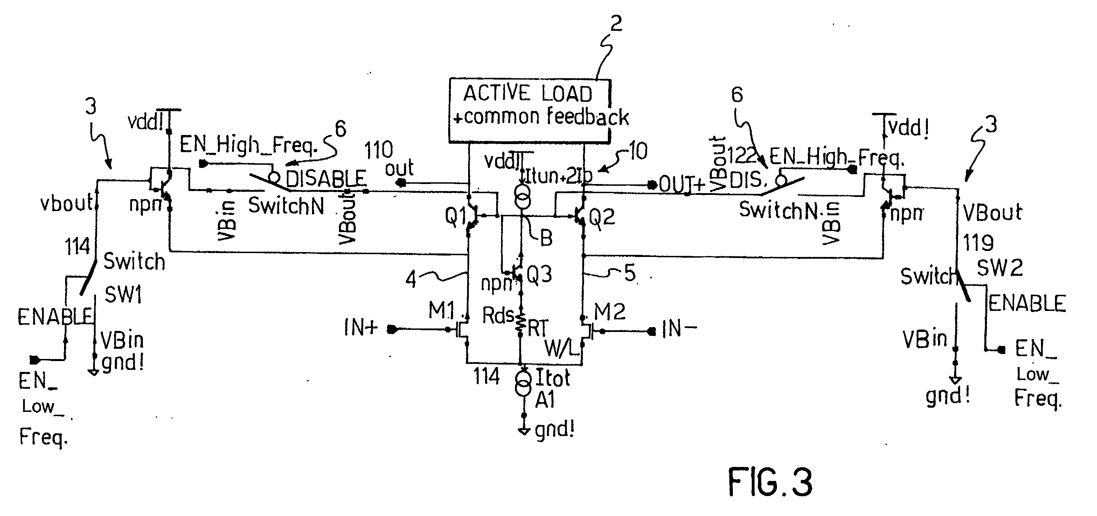

With reference to the above FIGS and in particular the embodiment of FIG 3, reference number 10 indicates as a whole and schematically a transconductor differential stage provided in accordance with the present invention in conformity with BiCMOS technology.

The heart of stage 10 is a differential cell corresponding to the structure discussed above with reference to FIG 1 and accordingly there is now omitted a detailed description thereof to avoid complicating the following discussion of the present disclosure.

It should only be pointed out that stage 10 comprises two principal circuit branches 4 and 5, one for each of the differential inputs.

Advantageously in accordance with the present invention the stage 10 comprises a switching device 3 associated with each branch of stage 10.

The device 3 can modify the connections between the parasite capacitors present in the transconductor stage. For this purpose the device 3 comprises a microswitch SW normally open and driven in closing by a signal ENABLE_LOW_FREQ.

The microswitch SW is inserted between the node B of stage 10 and ground GND. It is recalled that the node B coincides with the point of connection between the bases B1 and B2 of the bipolar transistors Q1, Q2.

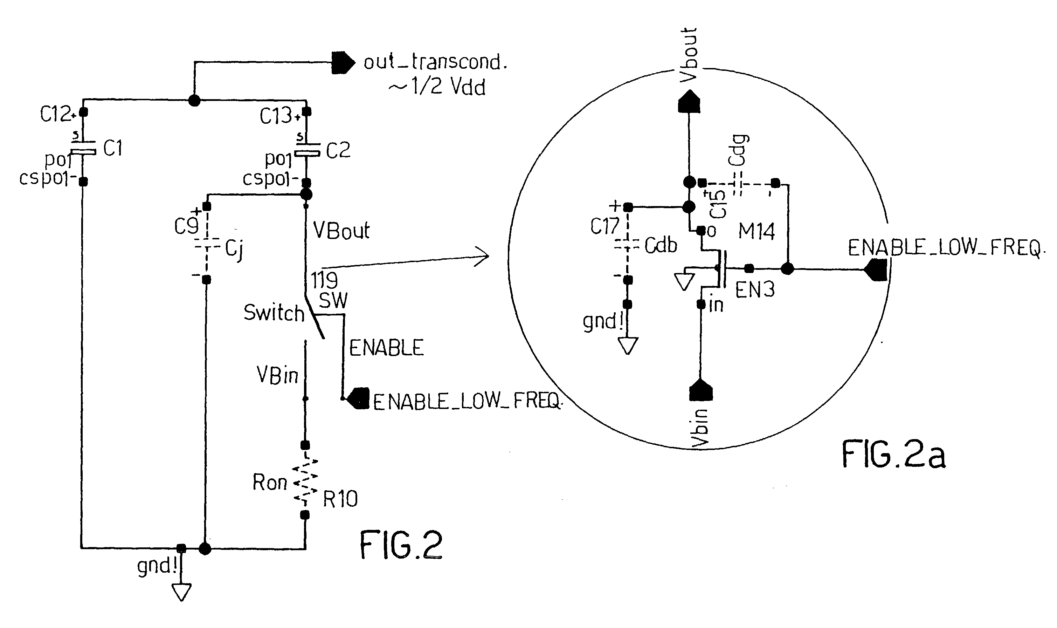

FIG 2 shows a detail of the switching device 3 in which are also indicated some capacitors present in stage 10 opposite the various components.

In particular the capacitors C1 and C2 are connected to the outputs of the transconductor and have a relatively high value while a capacitor Cj corresponds to the parasite capacitor of the transistor Q3.

The value of the equivalent capacitance seen at the output terminal of the transconductor with the contribution of these capacitors can be calculated by the following formula.$\text{Ceq = Cj * C2/(Cj + C2) + C1}$

A resistance Ron was indicated in series with the microswitch SW to represent the intrinsic resistance of the switch SW in the closing state. It is important that this resistance Rom be as low as possible.

FIG 2a shows in enlarged scale a possible embodiment of the switch SW which is proposed as the N-channel MOS transistor Ms with control or gate terminal Gs on which is applied the signal ENABLE_LOW_FREQ. The MOS Ms is chosen with large size to have low internal resistance Ron but this results in a shortcoming due to the presence of the high capacitors C1 and C2.

Indeed, the transistor Ms has its drain terminal connected to the node B and its source terminal connected to ground. Between the drain terminal and the gate terminal there is a parasite capacitor Cdg while between this drain terminal and the bulk of the transistor there is a second parasite capacitor Cdb.

It is just the presence of these intrinsic parasite capacitors in the switch SW which could limit its effectiveness.

To avoid this possible shortcoming the present invention proposes to insert even in the switching device a transistor Qx connected in parallel with the bipolar cascode transistor of the associated branch.

Specifically the device 3 associated with the first branch 4 of the stage 10 comprises a bipolar Q1x of type npn connected in a switchable manner in parallel with the bipolar transistor Q1. Between the base B1x of this transistor Q1x and ground GND is inserted the switch SW1.

In like manner the device 3 associated with the second branch 5 of the stage 10 comprises a bipolar Q2x of the npn type connected in a switchable manner in parallel with the bipolar transistor Q2. Between the base B2x of this transistor Q2x and ground GND is inserted the switch SW2.

Advantageously in each switching device 3 there is also provided a second microswitch indicated by reference number 6 and inserted in the connection between the base terminals of the bipolar transistors.

This second microswitch 6 is normally open and is driven in closing by a signal ENABLE_HIGH_FREQ. negated. The switches 6 can be provided by small transistors so as to not introduce additional parasite components.

When the switches 6 are driven in closing each bipolar transistor Q1 and Q2 of the stage 10 is connected in parallel with a like bipolar transistor Q1x and Q2x. Under these conditions the value of the transconductance gm decreases and the second equivalent pole of the transconductor the stage 10 is shifted to a lower frequency because of the parasite capacitor introduced by the emitter terminal of the added transistor Q1x or Q2x, but at the same time the pole of the transconductor given by the ratio gm:C falls because of the reduction of gm.

This fact can change the so-called phase excess of the transconductor 10 and, to keep any phase excess limited, there could be provided a stage with low nominal gain, i.e. a gain of the type controlled in its variations with respect to the nominal value. In this manner are eliminated as much as possible the changes in gain A with which the phase excess is linked.

These problems were faced in European patent application no. 94830390.4 filed by this applicant. In any case, the changes in phase excess called for in the present invention would occur only when the transconductor operates at low frequency and therefore does not negatively influence the high-frequency performance of the transconductor stage in accordance with the present invention.

Basically, the structure of the stage in accordance with the present invention allows changing the value of the transconductance gm and increasing the tuning range without impairing the frequency performance.

It is also possible to avoid switchings on the input signal and it is much easier to control the value of the transconductance gm through mere replication of the differential stage.

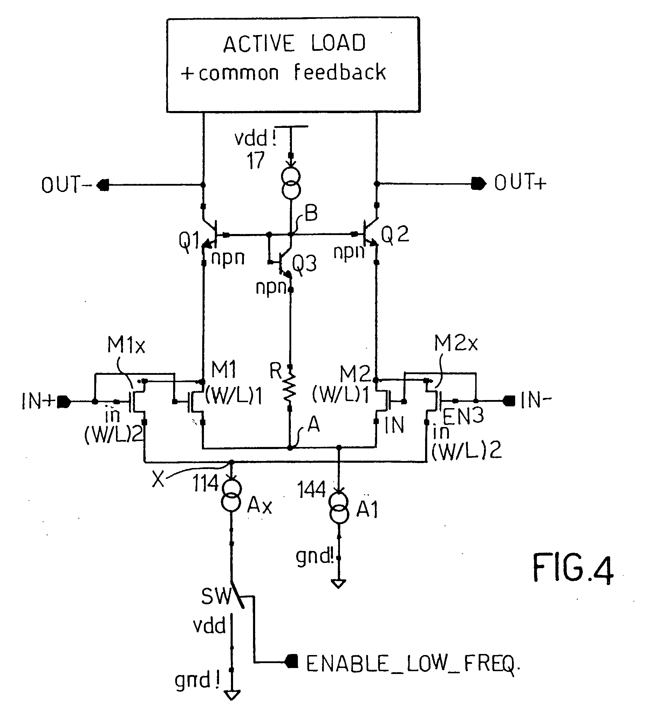

In a different embodiment falling within the scope of the present invention and which is now discussed with reference to FIG 4 it is possible to change the transconductance gm even by inserting respective MOS transistors in parallel with the MOS transistors M1, M2 of the input portion of the stage 10.

In this manner the ratio W:L of each of the input transistors M1, M2 is changed by the coupling in parallel of at least one MOS transistor.

Differently from the above solution, to avoid introducing switches on the input signals the added MOSes can be started or stopped by means of a current mirror structure.

With particular reference to FIG 4 it can be appreciated that with each of the MOS input transistors M1 and M2 there has been associated a corresponding added MOS transistor M1x and M2x.

The respective source terminals of the added transistors M1x and M2x are connected together in a common node X connected to ground through the series of a current generator Ax and a microswitch SWm.

The microswitch SWm can be provided by a small transistor if the generators A1 and Ax are provided in conformity with MOS technology but otherwise a larger transistor would be needed if the generators are in conformity with bipolar technology.

If gm1 indicates the transconductance associated with the input transistors M1 and M2 the transconductance associated with the added transistors M1x and M2x can be designated by gm2.

When the current generator Ax is on, it is possible to show that the transconductance of the stage 10 is given by the sum of the values gm1 and gm2. This happens with high-frequency applications, i.e. for high values of gm/C.

In low frequency operation on the other hand the transconductance of the stage 10 corresponds only to gml since the generator Ax is off.

Even this solution allows obtaining two different transconductance values depending on the requirements of the application.

In conclusion, the stage in accordance with the present invention makes it possible to adapt the band amplitude of the signal to be filtered while ensuring filtering linearity.

## Claims

1. BiCMOS Transconductor differential stage (10) for high frequency filters and of the type comprising an input circuit portion having signal inputs (IN+,IN-) and comprising a pair of MOS transistors (M1,M2) having their respective gate terminals (G1,G2) corresponding to said signal inputs and an output circuit portion having signal outputs (OUT-,OUT+) and comprising a pair of bipolar transistors (Q1,Q2) connected together with a common base in a circuit node (B) and inserted between said inputs (IN+,IN-) and said outputs (OUT-,OUT+) in cascode configuration and characterized in that it comprises a switching device (3) associated with at least one of said bipolar transistors (Q1,Q2) to change the connections between the parasite capacitors present in the transconductor stage with said device (3) comprising in addition at least one added bipolar transistor (Q1x,Q2x) connected in a switchable manner in parallel with the corresponding bipolar cascode transistor (Q1,Q2).

2. BiCMOS Stage in accordance with claim 1 and characterized in that the switching device (3) comprises a normally open first microswitch (SW) which is driven in a closing state by an enablement signal (ENABLE_LOW_FREQ), said first microswitch (SW) being inserted between said circuit node (B) and a reference voltage (GND).

3. BiCMOS Stage in accordance with claim 2 and characterized in that said first microswitch (SW) is an N-channel MOS transistor (Ms) with control or gate terminal (Gs) on which is applied the enablement signal (ENABLE_LOW_FREQ).

4. BiCMOS Stage in accordance with claim 3 and characterized in that said MOS transistor (Ms) is chosen with large size to have low internal resistance (Ron).

5. BiCMOS Stage in accordance with claim 2 and characterized in that the switching device (3) also comprises a second microswitch (6) inserted between said circuit node (B) and the base terminal of said added bipolar transistor (Q1x,Q2x).

6. BiCMOS Stage in accordance with claim 6 and characterized in that the first microswitch (SW) is inserted between the base terminal of the added bipolar transistor and the reference voltage (GND).

7. BiCMOS Stage in accordance with claim 1 and characterized in that it comprises a switching device (3) for each bipolar cascode transistor (Q1,Q2).

8. BiCMOS Stage in accordance with claim 1 and characterized in that it comprises respective added MOS transistors (M1x,M2x) connected in parallel with the MOS transistors (M1,M2) of the input portion to change the ratio W:L of each of the input transistors (M1,M2).

9. BiCMOS Stage in accordance with claim 1 and characterized in that the respective source terminals of the added transistors (M1x,M2x) are connected together in a common node (X) which is connected to ground (GND) through the series of a current generator (Ax) and a microswitch (SWm).

10. Pass-band filter of the second order and characterized in that it comprises at least one transconductor stage (1) in accordance with claim 1.

## Patentansprüche

1. Differentielle BiCMOS Transkonduktor-Stufe (10) für Hochfrequenzfilter und des Typs umfassend einen Eingangsschaltungsabschnitt mit Signaleingängen (IN+, IN-) und umfassend ein Paar von MOS Transistoren (M1, M2), deren jeweilige Gate-Anschlüsse (G1, G2) den Signaleingängen entsprechen, und einen Ausgangschaltungsabschnitt mit Signalausgängen (OUT-, OUT+) und umfassend ein Paar von Bipolar-Transistoren (Q1, Q2), die mit einer gemeinsamen Basis in einem Schaltungsknoten (B) zusammengeschalter und zwischen die Eingänge (IN+, IN-) und die Ausgänge (OUT-, OUT+) in einer Kaskadenkonfiguration eingefügt sind und dadurch gekennzeichnet, dass sie eine Schalteinrichtung (3), die zu wenigstens einem der Bipolar-Transistoren (Q1, Q2) gehört, um die Verbindungen zwischen den parasitären Kondensatoren, die in der Transkonduktorstufe vorhanden sind, zu ändern, wobei die Einrichtung (3) zusätzlich wenigstens einen hinzugefügten Bipolar-Transistor (Qlx, Q2x) umfasst, der in einer schaltbaren Weise parallel zu dem entsprechenden Bipolar-Kaskadentransistor (Q1, Q2) geschaltet ist.

2. BiCMOS Stufe nach Anspruch 1 und
***dadurch gekennzeichnet,***
dass die Schalteinrichtung (3) einen normalerweise offenen ersten Mikroschalter (SW) umfasst, der in einem schließenden Zustand von einem Freischaltsignal (ENABLE_LOW_FREQ) angesteuert wird, wobei der erste Mikroschalter (SW) zwischen den Schaltungsknoten (B) und einer Referenzspannung (GND) eingefügt ist.

3. BiCMOS Stufe nach Anspruch 2 und
***dadurch gekennzeichnet,***
dass der erste Mikroschalter (SW) ein N-Kanal MOS Transistor (Ms) mit einem Steuerungs- oder Gate-Anschluss (Gs) ist, an den das Freischaltsignal (ENABLE_LOW_FREQ) angelegt wird.

4. BiCMOS Stufe nach Anspruch 3 und
***dadurch gekennzeichnet,***
dass der MOS Transistor (Ms) mit einer großen Größe gewählt wird, so dass er einen geringen inneren Widerstand (Ron) aufweist.

5. BiCMOS Stufe nach Anspruch 2 und
***dadurch gekennzeichnet,***
dass die Schalteinrichtung (3) auch einen zweiten Mikroschalter (6) umfasst, der zwischen den Schaltungsknoten (B) und den Basisanschluss des hinzugefügten Bipolar-Transistors (Q1x, Q2x) eingefügt ist.

6. BiCMOS Stufe nach Anspruch 6 und
***dadurch gekennzeichnet,***
dass der erste Mikroschalter (SW) zwischen den Basisanschluss des hinzugefügten Bipolar-Transistors und die Referenzspannung (GND) eingefügt ist.

7. BiCMOS Stufe nach Anspruch 1 und
***dadurch gekennzeichnet,***
dass sie eine Schalteinrichtung (3) für jeden Bipolar-Kaskadentransistor (Q1, Q2) umfasst.

8. BiCMOS Stufe nach Anspruch 1 und
***dadurch gekennzeichnet,***
dass sie jeweilige hinzugefügte MOS Transistoren (M1x, M2x), die parallel zu den MOS Transistoren (M1, M2) des Eingangsabschnitts geschaltet sind, um das Verhältnis W:L jedes Eingangstransistors (M1, M2) zu ändern, umfasst.

9. BiCMOS Stufe nach Anspruch 1 und
***dadurch gekennzeichnet,***
dass die jeweiligen Quellenanschlüsse der hinzugefügten Transistoren (M1x, M2x) in einem gemeinsamen Knoten (X), der über die Reihenschaltung eines Stromgenerators (Ax) und eines Mikroschalters (SWm) mit Masse (GND) verbunden sind, zusammengeschaltet sind.

10. Bandpassfilter zweiter Ordnung und
***dadurch gekennzeichnet,***
dass es wenigstens eine Transkonduktor-Stufe (1) nach Anspruch 1 umfasst.

## Revendications

1. Etage différentiel transducteur de type BiCMOS (10) pour filtres haute fréquence, du type comprenant une partie de circuit d'entrée ayant des entrées de signal (IN+, IN-) et comportant deux transistors MOS (M1, M2) ayant leurs bornes de grilles respectives (G1, G2) qui correspondent aux entrées de signal et une partie de circuit de sortie ayant des sorties de signal (OUT-, OUT+) et comprenant deux transistors bipolaires (Q1, Q2) connectés l'un à l'autre avec une base commune sur un noeud de circuit (B) et insérés entre les entrées (IN+, IN-) et les sorties (OUT-, OUT+) en configuration cascode, caractérisé en ce qu'il comprend un dispositif de ccmmutation (3) associé à au moins l'un des transistors bipolaires (Q1, Q2) pour modifier les connexions entre les condensateurs parasites présents dans l'étage transconducteur, le dispositif (3) comprenant en outre au moins un transistor bipolaire supplémentaire (Q1x, Q2x) connecté de façon commutable en parallèle avec le transistor cascode bipolaire correspondant (Q1, Q2).

2. Etage BiCMOS selon la revendication 1, caractérisé en ce que le dispositif de commutation (3) comprend un premier microcommutateur (SW) normalement ouvert qui est piloté dans un état de fermeture par un signal de validation (ENABLE_LOW_FREQ), le premier microcommutateur (SW) étant inséré entre ledit noeud de circuit (B) et une tension de référence (GND).

3. Etage BiCMOS selon la revendication 2, caractérisé en ce que le premier microcommutateur (SW) est un transistor MOS à canal N (Ms) ayant une borne de commande ou de grille (Gs) sur laquelle est appliqué le signal de validation (ENABLE_LOW_FREQ).

4. Etage BiCMOS selon la revendication 3, caractérisé en ce que le transistor MOS (Ms) est choisi de grande dimension pour avoir une faible résistance interne (Ron).

5. Etage BiCMOS selon la revendication 2, caractérisé en ce que le dispositif de commutation (3) comprend également un second microcommutateur (6) inséré entre le noeud de circuit (B) et la borne de base du transistor bipolaire ajouté (Q1x, Q2x).

6. Etage BiCMOS selon la revendication 6, caractérisé en ce que le premier microcommutateur (SW) est inséré entre la borne de base du transistor bipolaire ajouté et la tension de référence (GND).

7. Etage BiCMOS selon la revendication 1, caractérisé en ce qu'il comprend le dispositif de commutation (3) pour chaque transistor cascode bipolaire (Q1, Q2).

8. Etage BiCMOS selon la revendication 1, caractérisé en ce qu'il comprend des transistors MOS ajoutés respectifs (M1x, M2x) connectés en parallèle avec les transistors MOS (M1, M2) de la partie d'entrée pour modifier le rapport W/L de chacun des transistors d'entrée (M1, M2).

9. Etage BiCMOS selon la revendication 1, caractérisé en ce que les bornes de source respectives des transistors ajoutés (M1x, M2x) sont connectées l'une à l'autre à un noeud commun (X) qui est relié à la masse (GND) par l'intermédiaire de la connexion en série d'un générateur de courant (Ax) et d'un microcommutateur (SWm).

10. Filtre passe-bande du second ordre, caractérisé en ce qu'il comprend au moins un étage transconducteur selon la revendication 1.
